Europäisches Patentamt

European Patent Office

Office européen des brevets

(19)

(11) Veröffentlichungsnummer: **0 375 034**
**A2**

(12) **EUROPÄISCHE PATENTANMELDUNG**

(21) Anmeldenummer: **89203175.8**

(22) Anmeldetag: **13.12.89**

(51) Int. Cl.⁵ **H03B 5/12, H03J 7/04**

(30) Priorität: **19.12.88 AT 3081/88**

(43) Veröffentlichungstag der Anmeldung:
**27.06.90 Patentblatt 90/26**

(84) Benannte Vertragsstaaten:
**DE FR GB IT**

(71) Anmelder: **N.V. Philips' Gloeilampenfabrieken**
**Groenewoudseweg 1**
**NL-5621 BA Eindhoven(NL)**

(72) Erfinder: **Hasler, Rudolf**
**c/o INT. OCTROOIBUREAU B.V. Prof.**
**Holstlaan 6**
**NL-5656 AA Eindhoven(NL)**

(74) Vertreter: **Schoonheijm, Harry Barend et al**
**INTERNATIONAAL OCTROOIBUREAU B.V.**
**Prof.Holstlaan 6**
**NL-5656 AA Eindhoven(NL)**

(54) **Oszillator zur Anspeisung einer Mischstufe in einem Tuner.**

(57) Bei einem Oszillator (1) mit einem Parallelresonanzkreis (4), der zur Nachstimmung des Oszillators eine variable Kapazität enthält, die in Abhängigkeit einer Nachstimmregelgröße veränderbar ist, wobei die variable Kapazität durch die im Kollektorkreis eines Transistors auftretende Kapazität gebildet ist, ist vorgesehen, daß der Transistor durch einen separaten, an den Parallelresonanzkreis kollektorseitig kapazitiv angekoppelten, wechselstrommäßig in Basisgrundschaltung betriebenen Transistor (12) gebildet ist, dessen Arbeitspunkt in seinem Sättigungsbereich gewählt ist, wobei seiner Basis-Emitterstrecke die Nachstimmregelgröße zugeführt wird, die innerhalb ihres Regelbereiches die sich in ihrem Durchlaßbereich befindende Basis-Kollektordiode des Transistors einerseits weiter in ihren Durchlaßbereich hinein und andererseits von ihrem Durchlaßbereich heraus bis in ihren Sperrbereich hinein aussteuert.

Fig.1

## Oszillator zur Anspeisung einer Mischstufe in einem Tuner.

Die Erfindung betrifft einen Oszillator zur Anspeisung einer Mischstufe in einem Tuner mit einem Parallelresonanzkreis, der eine variable Kapazität enthält, die in Abhängigkeit einer Nachstimmregelgröße veränderbar ist, wobei die variable Kapazität durch die im Kollektorkreis eines Transistors auftretende Kapazität gebildet ist, die in Abhängigkeit der einem Elektrodenpaar des Transistors zugeführten Nachstimmregelgröße veränderbar ist. Ein derartiger nachstimmbarer Oszillator ist aus der US-PS 4 034 298 bekannt, wobei bei diesem Oszillator der Oszillatortransistor selbst die variable Kapazität bildet, dadurch, daß die Kapazität seiner Basis-Kollektordiode durch eine Nachstimmregelgröße verändert wird, die dem Kollektor des Transistors zugeführt wird. Entsprechend dem für einen Oszillatorbetrieb des Transistors erforderlichen Arbeitspunkt befindet sich dabei seine Basis-Kollektordiode stets im Sperrbereich, wodurch sich demgemäß nur relativ geringe Kapazitätsänderungen erzielen lassen.

Die Erfindung hat sich zum Ziel gesetzt, einen Oszillator der eingangs angeführten Gattung hinsichtlich seiner Nachstimmbarkeit zu verbessern, dahingehend, daß ein großer und stabiler Variationsbereich der für das Nachstimmen erforderlichen Kapazität erreicht wird, und zwar auch bei relativ geringen Werten der Versorgungsspannung für die Schaltungsanordnung. Erfindungsgemäß ist hiezu vorgesehen, daß der Transistor durch einen separaten, an den Parallelresonanzkreis kollektorseitig angekoppelten, wechselstrommäßig mit Basis und Emitter an Hasse liegenden Transistor gebildet ist, daß der Arbeitspunkt des Transistors so gewählt ist, daß sowohl seine Basis-Emitterdiode als auch seine Basis-Kollektordiode in Durchlaßrichtung vorgespannt sind, und daß die Nachstimmregel-größe der Basis-Emitterstrecke des Transistors zugeführt ist, wobei die Nachstimmregelgröße innerhalb ihres Regelbereiches die Basis-Kollektordiode einerseits weiter in ihren Durchlaßbereich hinein und andererseits bis in ihren Sperrbereich hinein aussteuert. Durch eine solche erfindungsgemäße Wahl des Arbeitspunktes des Transistors, bei dem sich dieser im Sättigungsbereich befindet, wobei sowohl seine Basis-Emitterdiode als auch seine Basis-Kollektordiode in Durchlaßrichtung vorgespannt sind, wird ein relativ großer Variationsbereich der sich ändernden Kapazität der Basis-Kollektordiode erhalten. Dabei war es vollkommen überraschend, daß der Transistor in einem solchen Arbeitspunkt überhaupt zufriedenstellend als variable Kapazität betrieben werden kann, da insbesondere in diesem Bereich der Kapazitätsverlauf der Basis-Kollektordiode bekanntlich stark nichtlinearen Charakter hat. Daß eine solche Betriebsweise trotzdem möglich ist, beruht darauf, daß durch die Nachstimmregelgröße innerhalb ihres Regelbereiches die Basis-Kollektordiode einerseits weiter in den Durchlaßbereich hinein ausgesteuert wird, wobei sich bekanntlich relativ große Kapazitätsänderungen ergeben, und andererseits auch bis in ihren Sperrbereich hinein ausgesteuert wird, wobei dann die Gleichspannungsverstärkung des Transistors zur Wirkung kommt und demgemäß für relativ große Änderungen der an der Basis-Kollektordiode anliegenden Spannung sorgt und damit wieder relativ große Kapazitätsänderungen bewirkt. Auf diese Weise werden somit innerhalb des Regelbereiches der Nachstimmregelgröße relativ große symmetrische Kapazitätsänderungen für das Nachstimmen des Oszillators erhalten. Außerdem kann die Schaltungsanordnung auch mit relativ niedrigen Werten für ihre Versorgungsspannung betrieben werden, wobei auch keine wie sonst vielfach erforderliche Stabilisierung derselben notwendig ist, da sich Änderungen der Versorgungsspannung praktisch nicht in störende Kapazitätsänderungen der Basis-Kollektordiode umsetzen, weil an sich der Arbeitspunkt des Transistors in seinem Sättigungsbereich gewählt ist, in dem sich Änderungen der Versorgungsspannung bekanntlich praktisch nicht auf seine Kollektorspannung und damit auch nicht auf die an seiner Basis-Kollektordiode anliegende Spannung auswirken und bei seiner nur einseitigen Steuerung aus dem Sättigungsbereich heraus die Kapazitätsänderungen seiner dann im Sperrbereich betriebenen Basis-Kollektordiode mit zunehmender an ihr anliegender Spannung rasch kleiner werden, so daß auch in diesem Fall ein diesbezüglicher Einfluß nicht mehr wesentlich ins Gewicht fällt. Weiters eignet sich eine derartige Schaltung auch sehr gut zur Ausbildung als integrierte Schaltung, da für relativ große Kapazitätsänderungen nur eine relativ kleine Kristallfläche für den Transistor benötigt wird.

Weiters hat sich als vorteilhaft erwiesen, wenn die Nachstimmregelgröße der Basis-Emitterstrecke des Transistors über ein RC-Glied zugeführt ist, wobei mit der Nachstimmregelgröße innerhalb ihres Regelbereiches die Basis-Kollektordiode einerseits so weit in ihren Durchlaßbereich hinein aussteuerbar ist, bis der Widerstand des RC-Gliedes im Zusammenwirken mit der Impedanz der Basis-Emitterstrecke des Transistors die an der Basis-Emitterstrecke auftretende und an der Basis-Kollektordiode anliegende Spannung im wesentlichen auf einen maximal erreichbaren Wert begrenzt, und andererseits so weit in ihren Sperrbereich hinein aussteuerbar ist, bis ihre Kapazität im wesentlichen keine Änderung mehr erfährt. Durch eine derartige Begrenzung der an der Basis-Kollektordiode anliegenden Spannung, sobald die Basis-Kollektordiode weiter in ihren Durchlaßbereich hinein ausgesteuert wird, tritt dann keine wesentliche Kapazitätsänderung mehr ein, ebenso wie dies der Fall ist, wenn die Basis-Kollektordiode weiter in ihren Sperrbereich hinein ausgesteuert wird. Auf diese Weise werden somit bei an sich relativ großen Kapazitätsänderungen gute symmetrische Eigenschaften für das Nachstimmen des Oszillators erhalten, wobei sich zufolge der beidseitigen Begrenzung der Kapazitätsänderung auch eine einwandfreie beidseitige Begrenzung des Haltebereiches des Oszillators ergibt, was für eine gute Abstimmbarkeit desselben wesentlich ist.

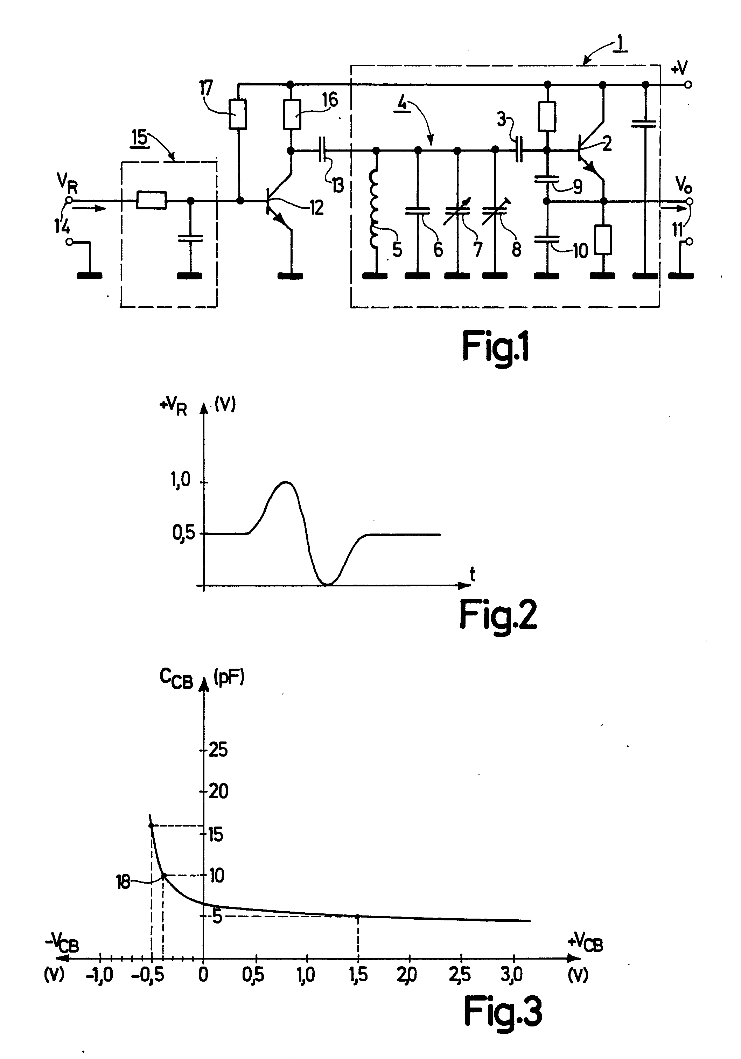

Die Erfindung wird im folgenden anhand der Zeichnung, in der ein Ausführungsbeispiel der Erfindung dargestellt ist, auf das sie jedoch nicht beschränkt sein soll, näher erläutert. Fig.1 zeigt das Schaltbild eines Oszillators, der zur Anspeisung einer Mischstufe in einem Tuner geeignet ist und der zu seiner Nachstimmbarkeit eine variable Kapazität aufweist, die in Abhängigkeit einer Nachstimmregelgröße veränderbar ist. Fig.2 zeigt ein Diagramm zur Erläuterung des Verlauf es der Nachstimmregelgröße, welche die variable Kapazität steuert. Fig.3 zeigt ein Diagramm über den Verlauf der im Kollektorkreis eines Transistors auftretenden Kapazität, die in Abhängigkeit der in Fig.2 angegebenen Nachstimmregelgröße veränderbar ist.

In Fig. 1 ist das Schaltbild eines Oszillators 1 angegeben, der einen Oszillatortransistor 2 aufweist, an den über einen Kondensator 3 ein Parallelresonanzkreis 4 angekoppelt ist, der aus einer Induktivität 5, einem Kondensator 6, einem Abstimmkondensator 7 und einem Abgleichkondensator 8 besteht. Der Oszillatortransistor 2 wird dabei in Kollektorgrundschaltung betrieben, wobei die Rückkopplung durch einen aus zwei Kondensatoren 9 und 10 gebildeten kapazitiven Spannungsteiler erfolgt, der zwischen der Basis des Oszillatortransistors 2 und dessen Emitter wirksam ist. Das Oszillatorsignal an sich wird vom Emitter des Oszillatortransistors 2 abgenommen, das dann am Ausgang 11 des Oszillators zur Verfügung steht, von dem her es einer Mischstufe in einem Tuner, die beide hier nicht näher angegeben sind, zugeführt werden kann. Die vorliegende Oszillatorschaltung an sich könnte natürlich auch im Rahmen des hiefür bekannten Standes der Technik anders ausgebildet sein, dies beispielsweise im Hinblick auf die gewählte Art und Weise der Rückkopplung. Entsprechendes gilt auch für die Wahl des Abstimmkondensators 7, der entweder durch einen Drehkondensator oder auch eine Kapazitätsdiode gebildet sein kann. Derartige Oszillatoren sind üblicherweise von einer aus dem mit dem Tuner und diesem nachfolgenden Signalverarbeitungsstufen verarbeiteten Nutzsignal gewonnenen Nachstimmregelgröße her nachstimmbar ausgebildet, um Fehlabstimmungen ausregeln zu können, was wie üblich mit sogenannten AFC-Schaltungen geschieht. An solche AFC-Schaltungen werden Anforderungen in verschiedener Hinsicht gestellt, nämlich dahingehend, daß sie keine Frequenzdrift bei Änderungen der Versorgungsspannung bewirken, daß sie eine symmetrische Wirkung aufweisen, wobei die Kapazitätsänderung beidseitig eines Arbeitspunktes annähernd linear mit der Regelgröße verläuft, daß sie einen vorgegebenen Fang- und Haltebereich für den Oszillator ergeben, wobei der Haltebereich nicht zu groß sein soll, um das Abstimmen nicht zu erschweren, und dergleichen mehr. Üblicherweise verwenden derartige AFC-Schaltungen eine in den Parallelresonanzkreis des Oszillators aufgenommene regelbare Impedanz in Form der Sperrschichtkapazität einer Halbleiterstrecke, beispielsweise einer Halbleiterdiode oder eines Transistors, im letzteren Fall beispielsweise die im Kollektorkreis eines Transistors auftretende Kapazität, um eine Nachstimmung des Oszillators zu erreichen.

Um nun die im vorstehenden angeführten Anforderungen auf einfache Weise zu erreichen, ist gemäß dem vorliegenden Ausführungsbeispiel die in den Parallelresonanzkreis aufgenommene variable Kapazität durch einen separaten Transistor 12 gebildet, der an den Parallelresonanzkreis 4 kollektorseitig mittels eines Kondensators 13 kapazitiv angekoppelt ist und wechselstrommäßig in Basisgrundschaltung betrieben wird, wobei seine Basis-Kollektordiode die variable Kapazität bildet. Die Nachstimmregelgröße, die auf übliche Weise mit einer hier nicht näher angegebenen Detektorschaltung gewonnen wird und ein Maß für die erforderliche Nachstimmung bildet, wird von einem Eingang 14 her der Basis-Emitterstrecke des Transistors 12 zugeführt, wobei im vorliegenden Fall zwischen den Eingang 14 und der Basis des Transistors 12 noch ein RC-Glied 15 eingeschaltet ist, auf dessen Wirkungsweise noch im nachfolgenden eingegangen wird. Wesentlich für die angestrebte Wirkungsweise ist nun, daß der Arbeitspunkt des Transistors 12, der bekanntlich im Zusammenhang mit der Versorgungsspannung durch seinen Kollektorwiderstand 16, seinen Basisvorwiderstand 17 und die an die Basis angekoppelte Ausgangsimpedanz der die Nachstimmregelgröße liefernden Quelle bestimmt ist, in seinem Sättigungsbereich gewählt ist, in dem sowohl seine Basis-Emitterdiode als auch seine Basis-Kollektordiode in Durchlaßrichtung vorgespannt sind, wobei dann die vom Eingang 14 her der Basis des Transistors 12 zugeführte Nachstimmregelgröße innerhalb ihres Regelbereiches die Basis-Kollektordiode des Transistors 12 einerseits weiter in ihren Durchlaßbereich hinein und andererseits bis in ihren Sperrbereich hinein ausgesteuert. Eine derartige Aussteuerung erfolgt dabei unter der Wirkung der in Fig.2 angegebenen Nachstimmregelgröße $V_R$, wobei bei von einem Ruhewert ausgehender ansteigender Spannung der Transistor 12 durch seinen dabei steigenden Kollektorstrom mehr in den Sättigungsbereich und bei gegenüber dem Ruhewert abfallender Spannung durch den dabei abnehmenden Kollektorstrom aus dem Sättigungsbereich heraus gesteuert wird. Dies bedeutet aber, daß im erstgenannten Fall die die variable Kapazität bildende Kapazität der Basis-Kollektordiode des Transistors 12, dadurch daß diese weiter in den Durchlaßbereich hinein ausgesteuert wird, relativ stark ansteigt und somit eine relativ große Kapazitätsänderung ergibt, wogegen im zweitgenannten Fall die Basis-Kollektordiode bis in ihren Sperrbereich hinein ausgesteuert wird, wobei dann die Gleichspannungsverstärkung des Transistors zur Wirkung kommt und demgemäß für relativ große Änderungen der an der Basis-Kollektordiode anliegenden Spannung sorgt und damit wieder eine relativ große Kapazitätsänderung ergibt.

Ein derartiger Verlauf der Kapazitätsänderung der Basiskollektordiode des Transistors 12 ist in Fig.3 angegeben, und zwar für einen Transistor wie er unter der Typenbezeichnung BC 548 im Handel erhältlich ist. In Fig.3 ist hiebei auf der Ordinate die mit $C_{CB}$ bezeichnete Kapazität der Basis-Kollektordiode und auf der Abszisse die Spannung $V_{CB}$, welche an der Basis-Kollektordiode anliegt, aufgetragen, wobei der Arbeitspunkt des Transistors mit 18 bezeichnet ist. In dem Bereich der negativen Spannung $V_{CB}$ befindet sich dabei die Basis-Kollektordiode in ihrem Durchlaßbereich, wogegen sie sich im Bereich der positiven Spannung $V_{CB}$ in ihrem Sperrbereich befindet. Wie aus diesem Diagramm der Fig.3 ersichtlich ist, ergeben bei sich in ihrem Durchlaßbereich befinden-der Basis-Kollektordiode bereits kleine Änderungen der an ihr anliegenden Spannung relativ große Kapazitätsänderungen, wogegen die Kapazitätsänderungen bei sich in ihrem Sperrbereich befindender Basis-Kollektordiode immer kleiner werden, je größer die dabei an ihr anliegende Spannung wird, was aber die Symmetrie der mit diesen Kapazitätsänderungen bewirkten Nachstimmung des Oszillators nicht beeinträchtigt, da, wie bereits erwähnt, in diesem Bereich die Gleichspannungsverstärkung des Transistors zur Wirkung kommt und demgemäß für relativ große Änderungen der an der Basis-Kollektordiode anliegenden Spannung sorgt, die dann wieder relativ große Kapazitätsänderungen bewirken. Zufolge der sich ergebenden relativ großen möglichen Kapazitätsänderung kann daher die Schaltungsanordnung auch mit einer relativ niedrigen Versorgungsspannung betrieben werden, da keine großen Spannungshübe er forderlich sind. Auch Änderungen der Versorgungsspannung haben dabei keinen wesentlichen Einfluß auf die Kapazitätsänderung der Basis-Kollektordiode, da sich der Transistor bei sich im Durchlaßbereich befindender Basis-Kollektordiode selbst im Sättigungsbereich befindet, in dem sich Änderungen der Versorgungsspannung bekanntlich praktisch nicht auf seine Kollektorspannung und damit auch nicht auf die an seiner Basis-Kollektordiode anliegende Spannung auswirken, wogegen bei sich in ihrem Sperrbereich befindender Basis-Kollektordiode mit zunehmender an ihr anliegender Spannung die Änderungen ihrer Kapazität immer kleiner werden, so daß auch in diesem Fall Änderungen der Versorgungsspannung nicht wesentlich ins Gewicht fallen.

Wie aus dem Vorstehenden ersichtlich ist, ergibt sich bei der Aussteuerung der Basis-Kollektordiode in ihren Sperrbereich hinein automatisch eine Begrenzung ihrer Kapazitätsänderungen, da mit zunehmender an ihr anliegender Sperrspannung diese Änderungen immer kleiner werden. Damit ergibt sich bei in ihrem Sperrbereich befindender Basis-Kollektordiode zufolge der abnehmenden Kapazitätsänderungen automatisch auch eine Begrenzung des Haltebereiches des Oszillators bei seiner Nachstimmung in dieser Richtung. Ist nun außerdem wie beim vorliegenden Ausführungsbeispiel das bereits erwähnte RC-Glied 15 vorgesehen, so wird auch eine Begrenzung des Haltebereiches des Oszillators in Richtung seiner Nachstimmung mit größeren Kapazitätswerten erhalten. Dies beruht darauf, daß der Widerstand des RC-Gliedes 15 im Zusammenwirken mit der Impedanz der Basis-Emitterstrecke des Transistors 12 die an der Basis-Emitterstrecke auftretende Spannung im wesentlichen auf einen maximal erreichbaren Wert begrenzt, wodurch sich auch die an der Basis-Kollektordiode anliegende Spannung nicht mehr ändert und somit keine weiteren Kapazitätsänderungen der sich dabei in ihrem Durchlaßbereich befindenden Basis-Kollektordiode ergeben. Wie aus Fig.3 ersichtlich ist, tritt im vorliegenden Fall eine derartige Begrenzung der Kapazitätsänderung bei etwa 0,5V der an der Basis-Kollektordiode anliegenden Spannung in Durchlaßrichtung ein. Bei sich im Sperrbereich befindender Basis-Kollektordiode tritt eine derartige wie bereits beschriebene Begrenzung der Kapazitätsän derung bei etwa 1,5V der an ihr anliegenden Spannung ein. Auf diese Weise wird somit eine einwandfreie beidseitige Begrenzung des Haltebereiches des Oszillators erreicht, was für eine gute Abstimmbarkeit desselben wesentlich ist.

Insgesamt gesehen wird somit auf die beschriebene Art und Weise ein Oszillator erhalten, der sehr gute Nachstimmeigenschaften aufweist.

Zufolge der erzielbaren relativ großen Kapazitätsänderung eignet sich eine derartige Schaltung auch sehr gut zur Ausbildung als integrierte Schaltung, da nur eine relativ kleine Kristallfläche für den Transistor 12 benötigt wird. Selbstverständlich besteht noch eine Reihe von Abwandlungsmöglichkeiten des im vorstehenden beschriebenen Ausführungsbeispieles, ohne daß dabei der Rahmen der Erfindung verlassen wird, in welchem Zusammenhang insbesondere die Art und Weise der Ausbildung des Oszillators an sich zu erwähnen ist.

**Ansprüche**

1. Oszillator zur Anspeisung einer Mischstufe in einem Tuner mit einem Parallelresonanzkreis, der eine variable Kapazität enthält, die in Abhängigkeit einer Nachstimmregelgröße veränderbar ist, wobei die variable Kapazität durch die im Kollektorkreis eines Transistors auftretende Kapazität gebildet ist, die in Abhängigkeit der einem Elektrodenpaar des Transistors zugeführten Nachstimmregelgröße veränderbar ist, dadurch gekennzeichnet, daß der Transistor durch einen separaten, an den Parallelresonanzkreis kollektorseitig angekoppelten, wechselstrommäßig mit Basis und Emitter an Masse liegenden Transistor gebildet ist, daß der Arbeitspunkt des Transistors so gewählt ist, daß sowohl seine Basis-Emitterdiode als auch seine Basis-Kollektordiode in Durchlaßrichtung vorgespannt sind, und daß die Nachstimmregelgröße der Basis-Emitterstrecke des Transistors zugeführt ist, wobei die Nachstimmregelgröße innerhalb ihres Regelbereiches die Basis-Kollektordiode einerseits weiter in ihren Durchlaßbereich hinein und andererseits bis in ihren Sperrbereich hinein aussteuert.

2. Oszillator nach Anspruch 1, dadurch gekennzeichnet, daß die Nachstimmregelgröße der Basis-Emitterstrecke des Transistors über ein RC-Glied zugeführt ist, wobei mit der Nachstimmregelgröße innerhalb ihres Regelbereiches die Basis-Kollektordiode einerseits so weit in ihren Durchlaßbereich hinein aussteuerbar ist, bis der Widerstand des RC-Gliedes im Zusammenwirken mit der Impedanz der Basis-Emitterstrecke des Transistors die an der Basis-Emitterstrecke auftretende und an der Basis-Kollektordiode anliegende Spannung im wesentlichen auf einen maximal erreichbaren Wert begrenzt, und andererseits so weit in ihren sperrbereich hinein aussteuerbar ist, bis ihre Kapazität im wesentlichen keine Änderung mehr erfährt.

Fig.1

Fig.2

Fig.3

PHO 88-514